(19) Europäisches Patentamt

European Patent Office

Office européen des brevets

(11) **EP 4 568 109 A2**

(12) **EUROPEAN PATENT APPLICATION**

(43) Date of publication:
**11.06.2025 Bulletin 2025/24**

(21) Application number: **24212408.9**

(22) Date of filing: **12.11.2024**

(51) International Patent Classification (IPC):
*H03K 3/356* (2006.01)

(52) Cooperative Patent Classification (CPC):
H03K 3/356182

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **05.12.2023 KR 20230174938**
**22.04.2024 KR 20240053539**

(71) Applicant: **Samsung Electronics Co., Ltd.**
**Suwon-si, Gyeonggi-do 16677 (KR)**

(72) Inventors:
• **LEE, Sangkyu**
**16677 Suwon-si (KR)**

• **KIM, Yongwoo**
**16677 Suwon-si (KR)**
• **PARK, Jungyeong**
**16677 Suwon-si (KR)**
• **LEE, Jungho**
**16677 Suwon-si (KR)**
• **LIM, Sangjin**
**16677 Suwon-si (KR)**
• **CHO, Youngjae**
**16677 Suwon-si (KR)**
• **CHOI, Michael**
**16677 Suwon-si (KR)**
• **HEO, Donghun**
**16677 Suwon-si (KR)**

(74) Representative: **Marks & Clerk LLP**
**15 Fetter Lane**
**London EC4A 1BW (GB)**

(54) **LEVEL SHIFTER**

(57) A level shifter includes an input circuit (110) configured to invert an input voltage (VIN) to output a first inverted voltage (VI1) and a second inverted voltage (VI2), wherein the input voltage (VIN) swings between a first ground voltage (VSS1) and a first power supply voltage (VDD1), a protection circuit (120) including at least one pair of transistors (PT1 to PT6) sharing a gate terminal to adjust, based on the first inverted voltage (VI1) and the second inverted voltage (VI2), one of a first intermediate voltage (VM1) and a second intermediate voltage (VM2) of the protection circuit (120), a cross-coupling circuit (130) configured to adjust the other of the first intermediate voltage (VM1) and the second intermediate voltage (VM2), and an output circuit (140) configured to invert the first intermediate voltage (VM1) to output an output voltage that swings between a second ground voltage (VSS2) and a second power supply voltage (VDD2).

EP 4 568 109 A2

FIG. 3

**Description**

BACKGROUND

Embodiments of the present disclosure relate to a level shifter, and more particularly, to a level shifter with a limited voltage swing range.

Electronic devices may include various components that may operate in the same or different voltage domains. Components in the same voltage domain may share the same power supply voltage and the same ground voltage. Conversely, components in different voltage domains may use different power supply voltages and different ground voltages.

Level shifters may be used to interface components across different voltage domains. A level shifter converts a voltage from one voltage domain, which ranges between a first ground voltage level and a first power supply voltage level, to a voltage in another voltage domain, which ranges swings between a second ground voltage level and a second power supply voltage level). If a level shifter malfunctions, damage may occur to components relying on the voltage generated by the level shifter. Accordingly, various methods have been studied to prevent level shifters from malfunctioning.

SUMMARY

One or more embodiments of the present disclosure relate to a level shifter configured to minimize malfunctions or reduce susceptibility to failures, to provide improved performance.

According to an aspect of the disclosure, a level shifter may include: an input circuit configured to invert an input voltage to output a first inverted voltage and a second inverted voltage, wherein the input voltage swings between a first ground voltage and a first power supply voltage; a protection circuit including at least one pair of transistors having a shared gate to adjust, based on the first inverted voltage and the second inverted voltage, one of a first intermediate voltage and a second intermediate voltage of the protection circuit; a cross-coupling circuit configured to adjust an other of the first intermediate voltage and the second intermediate voltage; and an output circuit configured to invert the first intermediate voltage to output an output voltage that swings between a second ground voltage and a second power supply voltage.

According to another aspect of the disclosure, a level shifter may include: an input circuit configured to invert an input voltage to output a first inverted voltage and a second inverted voltage, wherein the input voltage swings between a first ground voltage level and a first power supply voltage level; a protection circuit configured to adjust, based on the first inverted voltage and the second inverted voltage, one of a first intermediate voltage and a second intermediate voltage; a cross-coupling circuit configured to adjust an other of the first intermediate voltage and the second intermediate voltage; an output circuit configured to invert the first intermediate voltage to output an output voltage that swings between a second ground voltage level and a second power supply voltage level; and a metastable state-preventing circuit configured to allow the first intermediate voltage and the second intermediate voltage to escape from a metastable voltage level when the first intermediate voltage and the second intermediate voltage are at the metastable voltage level.

According to another aspect of the disclosure, a level shifter may include: an input circuit configured to invert an input voltage to output a first inverted voltage and a second inverted voltage, wherein the input voltage swings between a first ground voltage level and a first power supply voltage level; a protection circuit configured to adjust, based on the first inverted voltage and the second inverted voltage, one of a first intermediate voltage and a second intermediate voltage; a cross-coupling circuit configured to adjust an other of the first intermediate voltage and the second intermediate voltage; an output circuit configured to invert the first intermediate voltage to output an output voltage that swings between a second ground voltage level and a second power supply voltage level; and an auxiliary circuit connected to a bias voltage and configured to assist in adjusting the first intermediate voltage and the second intermediate voltage.

At least some of the above and other features of the invention are set out in the claims.

BRIEF DESCRIPTION OF THE DRAWINGS

Embodiments will be more clearly understood from the following detailed description taken in conjunction with the accompanying drawings in which:

FIG. 1 is a block diagram showing a level shifter according to one or more embodiments;
FIG. 2 is a diagram illustrating the relationship between an input voltage and an output voltage of a level shifter according to one or more embodiments;
FIG. 3 is a circuit diagram showing a level shifter according to one or more embodiments;
FIG. 4 is a table showing a change in voltage according to a level of input voltage that is input to a level shifter according to one or more embodiments;
FIG. 5 is a table showing voltages input to and output from a metastable state-preventing circuit and states of metastable switching elements in a level shifter according to one or more embodiments;

FIG. 6 is a block diagram showing a bias generation circuit of a level shifter according to one or more embodiments;

FIG. 7 is a circuit diagram showing an example of a bias generation circuit of a level shifter according to one or more embodiments;

FIG. 8 is a block diagram showing another example of a level shifter according to one or more embodiments;

FIG. 9 is a circuit diagram showing another example of a level shifter according to one or more embodiments; and

FIG. 10 is a block diagram showing a system including a level shifter according to one or more embodiments.

DETAILED DESCRIPTION OF THE EMBODIMENTS

Example embodiments are described in greater detail below with reference to the accompanying drawings.

In the following description, like drawing reference numerals are used for like elements, even in different drawings. The matters defined in the description, such as detailed construction and elements, are provided to assist in a comprehensive understanding of the example embodiments. However, it is apparent that the example embodiments can be practiced without those specifically defined matters. Also, well-known functions or constructions are not described in detail since they would obscure the description with unnecessary detail.

Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, all of a, b, and c, or any variations of the aforementioned examples.

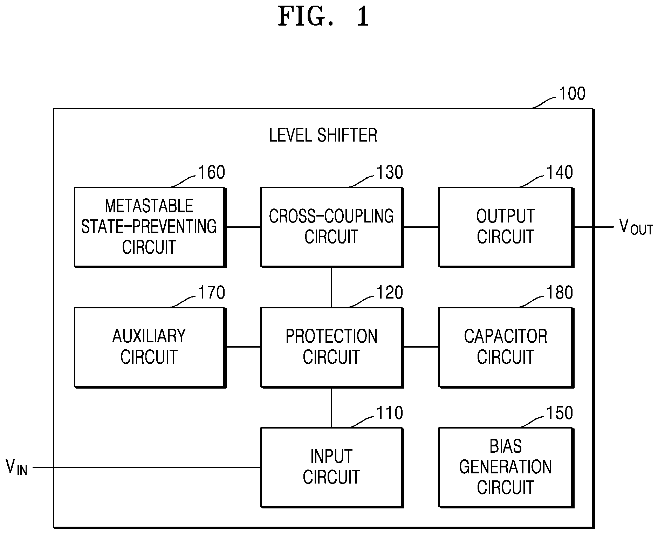

FIG. 1 is a block diagram showing a level shifter 100 according to one or more embodiments.

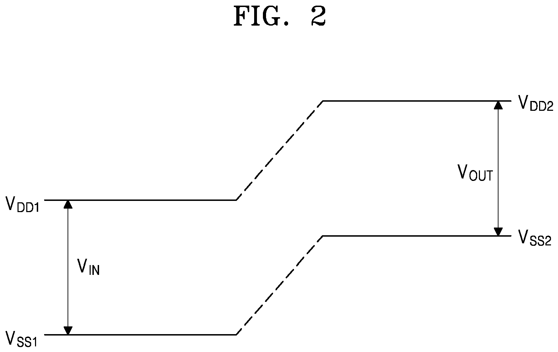

Referring to FIG. 1, the level shifter 100 according to one or more embodiments may receive an input voltage $V_{IN}$. The level shifter 100 may convert the voltage level of the input voltage $V_{IN}$ and generate an output voltage $V_{OUT}$. The level shifter 100 may output the output voltage $V_{OUT}$ generated based on the input voltage $V_{IN}$. Examples of the voltage levels of the input voltage $V_{IN}$ and the output voltage $V_{OUT}$ are described below with reference to FIG. 2.

The level shifter 100 according to one or more embodiments may include an input circuit 110, a protection circuit 120, a cross-coupling circuit 130, and an output circuit 140. The level shifter 100 according to one or more embodiments may further include at least one of a bias generation circuit 150, a metastable state-preventing circuit 160, an auxiliary circuit 170, and a capacitor circuit 180.

The input circuit 110 may invert and output the input voltage $V_{IN}$.

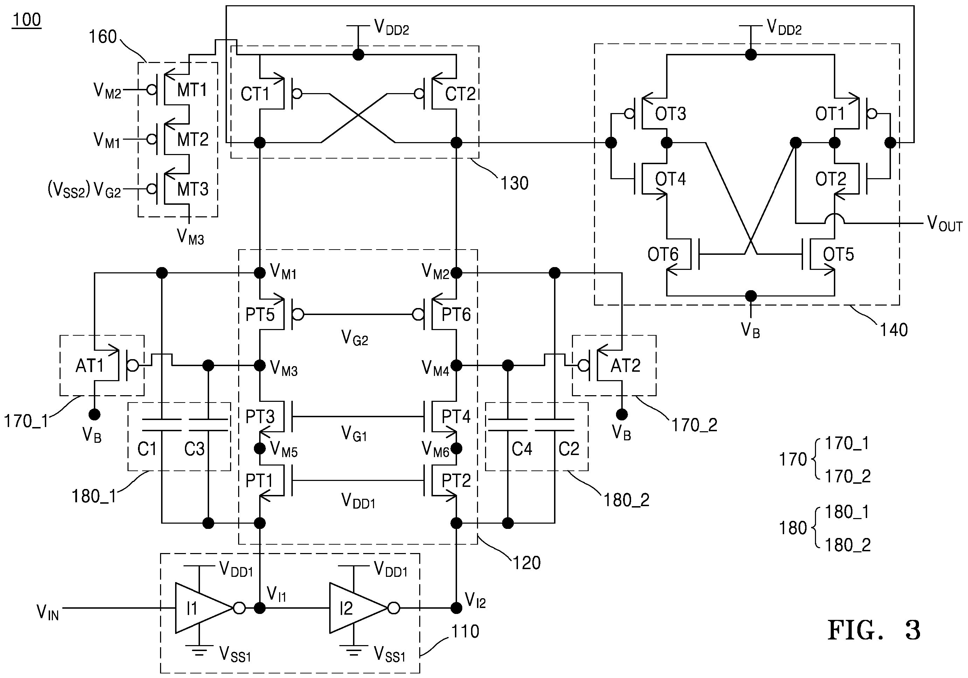

In more detail, the input circuit 110 may receive an input voltage that swings between a first ground voltage level and a first power supply voltage level. The input circuit 110 may invert the input voltage to generate a first inverted voltage and a second inverted voltage. In this case, the input circuit 110 may generate the first inverted voltage and the second inverted voltage using inverters. The first inverted voltage may include a voltage generated by inverting the input voltage. The second inverted voltage may include a voltage generated by inverting the first inverted voltage and may be the same as the input voltage. The input circuit 110 may output the first inverted voltage and the second inverted voltage to the protection circuit 120. The structure and operation of the input circuit 110 are described in more detail with reference to FIG. 3 below.

The protection circuit 120 may adjust either a first intermediate voltage or a second intermediate voltage based on the first inverted voltage and the second inverted voltage.

In more detail, the protection circuit 120 may be connected to the input circuit 110. The protection circuit 120 may receive a first inverted voltage and a second inverted voltage from the input circuit 110. The protection circuit 120 may include a plurality of protection switching elements. The protection circuit 120 may adjust, based on the first inverted voltage and the second inverted voltage, one of the first intermediate voltage and the second intermediate voltage using the plurality of protection switching elements. The structure and operation of the protection circuit 120 are described in more detail with reference to FIG. 3 below.

The cross-coupling circuit 130 may adjust the other of the first intermediate voltage and the second intermediate voltage.

In more detail, the cross-coupling circuit 130 may be connected to the protection circuit 120. The cross-coupling circuit 130 may adjust the other of the first intermediate voltage and the second intermediate voltage, which has not been adjusted by the protection circuit 120. For example, when the protection circuit 120 has adjusted the first intermediate voltage, the cross-coupling circuit 130 may adjust the second intermediate voltage. Conversely, when the protection circuit 120 has adjusted the second intermediate voltage, the cross-coupling circuit 130 may adjust the first intermediate voltage. The structure and operation of the cross-coupling circuit 130 are described in more detail with reference to FIG. 3 below.

The output circuit 140 may invert the first intermediate voltage and output the output voltage.

In more detail, the output circuit 140 may be connected to the cross-coupling circuit 130. The output circuit 140 may receive the first intermediate voltage. The output circuit 140 may invert the first intermediate voltage and output the output voltage. In this case, the output voltage may swing between a second ground voltage level and a second power supply voltage level. The second ground voltage level may be higher than the first ground voltage level, and the second power supply voltage level may be higher than the first power supply voltage level. The structure and operation of the output circuit 140 are described in more detail with reference to FIG. 3 below.

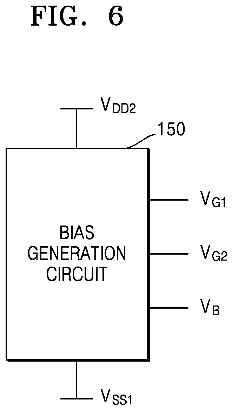

The bias generation circuit 150 may generate various types of voltages. The bias generation circuit 150 may be connected to a second power supply voltage terminal and a first ground voltage terminal. The bias generation circuit 150 may generate a first gate voltage, a second gate voltage, and a bias voltage based on a second power supply voltage and a first ground voltage. The first gate voltage, the second gate voltage, and the bias voltage generated by the bias generation circuit 150 may be input to the protection circuit 120, the output circuit 140, the metastable state-preventing circuit 160, and the auxiliary circuit 170. The structure and operation of the bias generation circuit 150 are described in more detail with reference to FIG. 6 below.

FIG. 1 illustrates that the bias generation circuit 150 is located inside the level shifter 100, but the embodiment is not limited thereto. For example, the bias generation circuit 150 may be separately provided outside the level shifter 100.

The metastable state-preventing circuit 160 may operate such that when the first intermediate voltage and the second intermediate voltage are at a metastable voltage level, the first intermediate voltage and the second intermediate voltage are allowed to escape from the metastable voltage level. A metastable voltage level may refer to a voltage level in an unstable or indeterminate state. Metastability may occur when a signal is not fully settled between a low voltage level and a high voltage level and is caught in an intermediate or unstable state. For example, a metastable voltage level may be a voltage level between a second power supply voltage level ($V_{DD2}$) and a second ground voltage level ($V_{SS2}$).

In more detail, the metastable state-preventing circuit 160 may receive the first intermediate voltage and the second intermediate voltage. The metastable state-preventing circuit 160 may include a plurality of metastable switching elements. When the first intermediate voltage and the second intermediate voltage are at a metastable voltage level, the metastable state-preventing circuit 160 may allow the first intermediate voltage and the second intermediate voltage to escape from the metastable voltage level by using the second power supply voltage. The structure and operation of the metastable state-preventing circuit 160 are described in more detail with reference to FIG. 3 below.

The auxiliary circuit 170 may be connected to the bias voltage and assist in adjusting the first intermediate voltage and the second intermediate voltage. The auxiliary circuit 170 may be connected to the protection circuit 120 and configured such that the first intermediate voltage and the second intermediate voltage adjusted by the protection circuit 120 have appropriate voltage levels. The structure and operation of the auxiliary circuit 170 are described in more detail with reference to FIG. 3 below.

The capacitor circuit 180 may assist in adjusting the voltage levels of the first intermediate voltage and the second intermediate voltage when the voltage level of the input voltage changes. The capacitor circuit 180 may be connected to the protection circuit 120 and configured such that the first intermediate voltage and the second intermediate voltage adjusted by the protection circuit 120 are adjusted at a high speed. The structure and operation of the capacitor circuit 180 are described in more detail with reference to FIG. 3 below.

FIG. 2 is a diagram illustrating the relationship between an input voltage $V_{IN}$ and an output voltage $V_{OUT}$ of a level shifter according to one or more embodiments.

Referring to FIG. 2, the input voltage $V_{IN}$ may swing between a first ground voltage level (Vssi) and a first power supply voltage level ($V_{DD1}$).

The input voltage $V_{IN}$ may have a first ground voltage level (Vssi) or the first power supply voltage level ($V_{DD1}$) according to a preset duty ratio. For example, the input voltage $V_{IN}$ may have the first power supply voltage level ($V_{DD1}$) during on-duty and the first ground voltage level (Vssi) during off-duty.

The output voltage $V_{OUT}$ may swing between a second ground voltage level ($V_{SS2}$) and a second power supply voltage level ($V_{DD2}$). In this case, the second ground voltage level ($V_{SS2}$) may be higher than the first ground voltage level (Vssi), and the second power supply voltage level ($V_{DD2}$) may be higher than the first power supply voltage level ($V_{DD1}$).

FIG. 2 illustrates that the first power supply voltage level ($V_{DD1}$) is higher than the second ground voltage level ($V_{SS2}$). However, the embodiment is not limited thereto. For example, a first power supply voltage level ($V_{DD1}$) may be equal to a second ground voltage level ($V_{SS2}$), or a first power supply voltage level ($V_{DD1}$) may be lower than a second ground voltage level ($V_{SS2}$). The range between the first ground voltage level Vssi and the first power supply voltage level $V_{DD1}$ may be shifted to the range between the second ground voltage level $V_{SS2}$ and the second power supply voltage level $V_{DD2}$ so that the shift from the first ground voltage level Vssi to the second ground voltage level $V_{SS2}$ is equal to the shift from the first power supply voltage level $V_{DD1}$ to second power supply voltage level $V_{DD2}$. However, the embodiment is not limited to this specific configuration, and different shift amounts may be applied to Vssi and $V_{DD1}$.

The output voltage $V_{OUT}$ may have the second ground voltage level ($V_{SS2}$) or the second power supply voltage level ($V_{DD2}$) depending on the input voltage $V_{IN}$. For example, when the input voltage $V_{IN}$ is at the first ground voltage level (Vssi), the output voltage $V_{OUT}$ may have the second ground voltage level ($V_{SS2}$). Also, when the input voltage $V_{IN}$ is at the first power supply voltage level ($V_{DD1}$), the output voltage $V_{OUT}$ may have the second power supply voltage level ($V_{DD2}$). However, the embodiment is not limited thereto. In another example, when the input voltage $V_{IN}$ is at the first ground voltage level (Vssi), the output voltage $V_{OUT}$ may have the second power supply voltage level ($V_{DD2}$). Also, when the input voltage $V_{IN}$ is at the first power supply voltage level ($V_{DD1}$), the output voltage $V_{OUT}$ may have the second ground voltage level ($V_{SS2}$).

FIG. 3 is a circuit diagram showing a level shifter 100 according to one or more embodiments.

Referring to FIG. 3, the level shifter 100 may include an input circuit 110, a protection circuit 120, a cross-coupling circuit 130, an output circuit 140, a metastable state-preventing circuit 160, auxiliary circuits 170_1 and 170_2, and capacitor circuits 180_1 and 180_2. Although not shown in the embodiment of FIG. 3, the level shifter 100 may further include a bias generation circuit 150.

A plurality of switching elements in the embodiment of FIG. 3 may include metal oxide silicon field effect transistors (MOSFETs), but the embodiment is not limited thereto. However, the following description focuses on an embodiment in which the plurality of switching elements include MOSFETs.

Hereinafter, the first ground voltage level (Vssi) includes a voltage level capable of turning off an n-channel metal-oxide semiconductor (NMOS). For example, the first ground voltage level (Vssi) may be 0 V. Also, the first power supply voltage level ($V_{DD1}$) includes a voltage level capable of turning on the NMOS. For example, the first power supply voltage level ($V_{DD1}$) may be 0.7 V. The second ground voltage level ($V_{SS2}$) includes a voltage level capable of turning on a p-channel metal-oxide semiconductor (PMOS). For example, the second ground voltage level ($V_{SS2}$) may be 0.5 V. Also, the second power supply voltage level ($V_{DD2}$) includes a voltage level capable of turning off the PMOS. For example, the second power supply voltage level ($V_{DD2}$) may be 1.2 V.

The input circuit 110 may include a first inverter I1 and a second inverter I2.

The first inverter I1 may be connected between a first power supply voltage terminal ($V_{DD1}$) and a first ground voltage terminal (Vssi). An input terminal of the first inverter I1 may be connected to an input terminal to which the input voltage $V_{IN}$ is applied. An output terminal of the first inverter I1 may be connected to an input terminal of the second inverter I2 and the protection circuit 120. The first inverter I1 may invert the input voltage $V_{IN}$ and output a first inverted voltage $V_{I1}$.

In more detail, the first inverter I1 may generate the first inverted voltage $V_{I1}$ by inverting the input voltage $V_{IN}$. For example, when the input voltage $V_{IN}$ is at the first ground voltage level (Vssi), the first inverter I1 may generate the first inverted voltage $V_{I1}$ having the first power supply voltage level ($V_{DD1}$). Also, when the input voltage $V_{IN}$ is at the first power supply voltage level ($V_{DD1}$), the first inverter I1 may generate the first inverted voltage $V_{I1}$ having the first ground voltage level (Vssi). The first inverter I1 may output the generated first inverted voltage $V_{I1}$ to the protection circuit 120.

The second inverter I2 may be connected between the first power supply voltage terminal ($V_{DD1}$) and the first ground voltage terminal (Vssi). The input terminal of the second inverter I2 may be connected to the output terminal of the first inverter I1. An output terminal of the second inverter I2 may be connected to the protection circuit 120. The second inverter I2 may invert the first inverted voltage $V_{I1}$ and output a second inverted voltage $V_{I2}$.

In more detail, the second inverter I2 may generate the second inverted voltage $V_{I2}$ by inverting the first inverted voltage $V_{I1}$. For example, when the first inverted voltage $V_{I1}$ is at the first power supply voltage level ($V_{DD1}$), the second inverter I2 may generate the second inverted voltage $V_{I2}$ having the first ground voltage level (Vssi). Also, when the first inverted voltage $V_{I1}$ is at the first ground voltage level (Vssi), the second inverter I2 may generate the second inverted voltage $V_{I2}$ having the first power supply voltage level ($V_{DD1}$). The second inverter I2 may output the generated second inverted voltage $V_{I2}$ to the protection circuit 120.

The protection circuit 120 may include first to sixth protection switching elements PT1 to PT6. The first through sixth protection switching elements, PT1 to PT6, may be configured as three pairs of transistors, with each pair sharing a gate terminal.

The first protection switching element PT1 may include an NMOS. A gate terminal of the first protection switching element PT1 may be connected to the first power supply voltage terminal ($V_{DD1}$). In this case, the first protection switching element PT1 may be turned on based on a first power supply voltage $V_{DD1}$. A source terminal of the first protection switching element PT1 may be connected to the output terminal of the first inverter I1. In this case, the first protection switching element PT1 may receive the first inverted voltage $V_{I1}$ via the source terminal thereof. A drain terminal of the first protection switching element PT1 may be connected to the third protection switching element PT3.

The first protection switching element PT1 includes an NMOS, and the first power supply voltage $V_{DD1}$ is applied thereto via the gate terminal. Therefore, the first protection switching element PT1 may remain turned on. In this case, when the first inverted voltage $V_{I1}$ having the first ground voltage level (Vssi) is applied from the output terminal of the first inverter I1 to the source terminal of the first protection switching element PT1, the voltage level of a fifth intermediate voltage $V_{M5}$, which is the voltage at the drain terminal of the first protection switching element PT1, may include the first ground voltage level (Vssi). Conversely, when the first inverted voltage $V_{I1}$ having the first power supply voltage level ($V_{DD1}$) is applied from the output terminal of the first inverter I1 to the source terminal of the first protection switching element PT1, the voltage level of the fifth intermediate voltage $V_{M5}$ may include the second power supply voltage level ($V_{DD2}$).

The second protection switching element PT2 may include an NMOS. A gate terminal of the second protection switching element PT2 may be connected to the first power supply voltage terminal ($V_{DD1}$). In this case, the second protection switching element PT2 may be turned on based on the first power supply voltage $V_{DD1}$. A source terminal of the second protection switching element PT2 may be connected to the output terminal of the second inverter I2. In this case, the second protection switching element PT2 may receive the second inverted voltage $V_{I2}$ via the source terminal thereof. A drain terminal of the second protection switching element PT2 may be connected to the fourth protection switching element PT4.

The second protection switching element PT2 includes an NMOS, and the first power supply voltage $V_{DD1}$ is applied thereto via the gate terminal. Therefore, the second protection switching element PT2 may remain turned on. In this case, when the second inverted voltage $V_{I2}$ having the first ground voltage level (Vssi) is applied from the output terminal of the second inverter I2 to the source terminal of the second protection switching element PT2, the voltage level of a sixth intermediate voltage $V_{M6}$, which is the voltage at the drain terminal of the second protection switching element PT2, may include the first ground voltage level (Vssi). Conversely, when the second inverted voltage $V_{I2}$ having the first power supply voltage level ($V_{DD1}$) is applied from the output terminal of the second inverter I2 to the source terminal of the second protection switching element PT2, the voltage level of the sixth intermediate voltage $V_{M6}$ may include the second power supply voltage level ($V_{DD2}$).

The third protection switching element PT3 may include an NMOS. A gate terminal of the third protection switching element PT3 may be connected to a first gate voltage $V_{G1}$. The first gate voltage $V_{G1}$ may include a voltage generated by the bias generation circuit 150, and the first gate voltage $V_{G1}$ may have the same voltage level as the first power supply voltage $V_{DD1}$. In this case, the third protection switching element PT3 may be turned on based on the first gate voltage $V_{G1}$. The source terminal of the third protection switching element PT3 may be connected to the drain terminal of the first protection switching element PT1. In this case, the third protection switching element PT3 may receive the fifth intermediate voltage $V_{M5}$ via the source terminal thereof. A drain terminal of the third protection switching element PT3 may be connected to the fifth protection switching element PT5.

The third protection switching element PT3 includes an NMOS, and the first gate voltage $V_{G1}$, which has the same voltage level as the first power supply voltage $V_{DD1}$, is applied thereto via the gate terminal. Therefore, the third protection switching element PT3 may remain turned on. In this case, when the fifth intermediate voltage $V_{M5}$ having the first ground voltage level (Vssi) is applied from the drain terminal of the first protection switching element PT1 to the source terminal of the third protection switching element PT3, the voltage level of a third intermediate voltage $V_{M3}$, which is the voltage at the drain terminal of the third protection switching element PT3, may include the first ground voltage level (Vssi). Conversely, when the fifth intermediate voltage $V_{M5}$ having the second power supply voltage level ($V_{DD2}$) is applied from the drain terminal of the first protection switching element PT1 to the source terminal of the third protection switching element PT3, the voltage level of the third intermediate voltage $V_{M3}$ may include the second power supply voltage level ($V_{DD2}$).

The fourth protection switching element PT4 may include an NMOS. A gate terminal of the fourth protection switching element PT4 may be connected to the first gate voltage $V_{G1}$. In this case, the fourth protection switching element PT4 may be turned on based on the first gate voltage $V_{G1}$. The source terminal of the fourth protection switching element PT4 may be connected to the drain terminal of the second protection switching element PT2. In this case, the fourth protection switching element PT4 may receive the sixth intermediate voltage $V_{M6}$ via the source terminal thereof. A drain terminal of the fourth protection switching element PT4 may be connected to the sixth protection switching element PT6.

The fourth protection switching element PT4 includes an NMOS, and the first gate voltage $V_{G1}$, which has the same voltage level as the first power supply voltage $V_{DD1}$, is applied thereto via the gate terminal. Therefore, the fourth protection switching element PT4 may remain turned on. In this case, when the sixth intermediate voltage $V_{M6}$ having the first ground voltage level (Vssi) is applied from the drain terminal of the second protection switching element PT2 to the source terminal of the fourth protection switching element PT4, the voltage level of a fourth intermediate voltage $V_{M4}$, which is the voltage at the drain terminal of the fourth protection switching element PT4, may include the first ground voltage level (Vssi). Conversely, when the sixth intermediate voltage $V_{M6}$ having the second power supply voltage level ($V_{DD2}$) is applied from the drain terminal of the second protection switching element PT2 to the source terminal of the fourth protection switching element PT4, the voltage level of the fourth intermediate voltage $V_{M4}$ may include the second power supply voltage level ($V_{DD2}$).

The fifth protection switching element PT5 may include a PMOS. A gate terminal of the fifth protection switching element PT5 may be connected to a second gate voltage $V_{G2}$. The second gate voltage $V_{G2}$ may include a voltage generated by the bias generation circuit 150, and the second gate voltage $V_{G2}$ may have the same voltage level as a second ground voltage $V_{SS2}$. In this case, the fifth protection switching element PT5 may be turned on based on the second gate voltage $V_{G2}$. The drain terminal of the fifth protection switching element PT5 may be connected to the drain terminal of the third protection switching element PT3. In this case, the fifth protection switching element PT5 may receive the third intermediate voltage $V_{M3}$ via the drain terminal thereof. The source terminal of the fifth protection switching element PT5 may be connected to the cross-coupling circuit 130 and the output circuit 140.

The fifth protection switching element PT5 includes a PMOS, and the second gate voltage $V_{G2}$, which has the same voltage level as the second ground voltage $V_{SS2}$, is applied thereto via the gate terminal. Therefore, the fifth protection switching element PT5 may remain turned on. In this case, when the third intermediate voltage $V_{M3}$ having the first ground voltage level (Vssi) is applied from the drain terminal of the third protection switching element PT3 to the drain terminal of the fifth protection switching element PT5, the voltage level of a first intermediate voltage $V_{M1}$, which is the voltage at the source terminal of the fifth protection switching element PT5, may include the second ground voltage level ($V_{SS2}$). Conversely, when the third intermediate voltage $V_{M3}$ having the second power supply voltage level ($V_{DD2}$) is applied from the drain terminal of the third protection switching element PT3 to the drain terminal of the fifth protection switching element PT5, the voltage level of the first intermediate voltage $V_{M1}$ may include a second power supply voltage $V_{DD2}$ by the cross-coupling circuit 130, which is described below.

The sixth protection switching element PT6 may include a PMOS. A gate terminal of the sixth protection switching element PT6 may be connected to the second gate voltage $V_{G2}$. In this case, the sixth protection switching element PT6 may be turned on based on the second gate voltage $V_{G2}$. The drain terminal of the sixth protection switching element PT6 may be connected to the drain terminal of the fourth protection switching element PT4. In this case, the sixth protection switching element PT6 may receive the fourth intermediate voltage $V_{M4}$ via the drain terminal thereof. The source terminal of the sixth protection switching element PT6 may be connected to the cross-coupling circuit 130 and the output circuit 140.

The sixth protection switching element PT6 includes a PMOS, and the second gate voltage $V_{G2}$, which has the same voltage level as the second ground voltage $V_{SS2}$, is applied thereto via the gate terminal. Therefore, the sixth protection switching element PT6 may remain turned on. In this case, when the fourth intermediate voltage $V_{M4}$ having the first ground voltage level (Vssi) is applied from the drain terminal of the fourth protection switching element PT4 to the drain terminal of the sixth protection switching element PT6, the voltage level of a second intermediate voltage $V_{M2}$ may include the second ground voltage level ($V_{SS2}$). Conversely, when the fourth intermediate voltage $V_{M4}$ having the second power supply voltage level ($V_{DD2}$) is applied from the drain terminal of the fourth protection switching element PT4 to the drain terminal of the sixth protection switching element PT6, the voltage level of the second intermediate voltage $V_{M2}$ may include a second power supply voltage $V_{DD2}$ by the cross-coupling circuit 130, which is described below.

During an operation of the level shifter 100, the second power supply voltage $V_{DD2}$ may reach a normal voltage level (e.g., 1.2 V), and then, the first power supply voltage $V_{DD1}$ may reach a normal voltage level (e.g., 0.7 V). In this case, the gate terminal of the first protection switching element PT1 and the gate terminal of the second protection switching element PT2 may have a floating voltage level. Accordingly, the first protection switching element PT1 and the second protection switching element PT2 may not operate correctly, and as a result, it may be difficult to perform a protective function against damage from excessive voltage applied to a plurality of switching elements in the level shifter 100. To address this issue, the gate terminal of the third protection switching element PT3 and the gate terminal of the fourth protection switching element PT4 have the first gate voltage $V_{G1}$, and the third protection switching element PT3 and the fourth protection switching element PT4 may provide protection against damage from excessive voltage applied to the plurality of switching elements in the level shifter 100 instead of the first protection switching element PT1 and the second protection switching element PT2.

The cross-coupling circuit 130 may include a first cross-switching element CT1 and a second cross-switching element CT2.

The first cross-switching element CT1 may include a PMOS. The gate terminal of the first cross-switching element CT1 may be connected to the source terminal of the sixth protection switching element PT6. In this case, the first cross-switching element CT1 may be turned on or off based on the second intermediate voltage $V_{M2}$. The source terminal of the first cross-switching element CT1 may be connected to a second power supply voltage terminal ($V_{DD2}$). The drain terminal of the first cross-switching element CT1 may be connected to the source terminal of the fifth protection switching element PT5.

The first cross-switching element CT1 may be turned on when the second intermediate voltage $V_{M2}$ having the second ground voltage level ($V_{SS2}$) is applied thereto via the gate terminal. In this case, the second power supply voltage $V_{DD2}$ is applied via the source terminal of the first cross-switching element CT1, and thus, the first intermediate voltage $V_{M1}$, which is the voltage at the drain terminal of the first cross-switching element CT1, may have the second power supply voltage level ($V_{DD2}$). Conversely, the first cross-switching element CT1 may be turned off when the second intermediate voltage $V_{M2}$ having the second power supply voltage level ($V_{DD2}$) is applied thereto via the gate terminal.

The second cross-switching element CT2 may include a PMOS. The gate terminal of the second cross-switching element CT2 may be connected to the source terminal of the fifth protection switching element PT5. In this case, the second cross-switching element CT2 may be turned on or off based on the first intermediate voltage $V_{M1}$. The source terminal of the second cross-switching element CT2 may be connected to the second power supply voltage terminal ($V_{DD2}$). The drain terminal of the second cross-switching element CT2 may be connected to the source terminal of the sixth protection switching element PT6.

The second cross-switching element CT2 may be turned on when the first intermediate voltage $V_{M1}$ having the second ground voltage level ($V_{SS2}$) is applied thereto via the gate terminal. In this case, the second power supply voltage $V_{DD2}$ is applied via the source terminal of the second cross-switching element CT2, and thus, the second intermediate voltage $V_{M2}$, which is the voltage at the drain terminal of the second cross-switching element CT2, may have the second power supply voltage level ($V_{DD2}$). Conversely, the second cross-switching element CT2 may be turned off when the first intermediate voltage $V_{M1}$ having the second power supply voltage level ($V_{DD2}$) is applied thereto via the gate terminal.

The output circuit 140 may include first to sixth output switching elements OT1 to OT6.

The first output switching element OT1 may include a PMOS. The gate terminal of the first output switching element OT1 may be connected to the first intermediate voltage $V_{M1}$. The source terminal of the first output switching element OT1 may be connected to the second power supply voltage terminal ($V_{DD2}$). The drain terminal of the first output switching element OT1 may be connected to the drain terminal of the second output switching element OT2 and the gate terminal and output terminal of the sixth output switching element OT6.

The second output switching element OT2 may include an NMOS. The gate terminal of the second output switching element OT2 may be connected to the first intermediate voltage $V_{M1}$. The drain terminal of the second output switching element OT2 may be connected to the drain terminal of the first output switching element OT1 and the gate terminal and output terminal of the sixth output switching element OT6. The source terminal of the second output switching element OT2 may be connected to the drain terminal of the fifth output switching element OT5.

The first and second output switching elements OT1 and OT2 may operate as inverters. Therefore, when the first intermediate voltage $V_{M1}$ having the second ground voltage level ($V_{SS2}$) is applied to the gate terminals of the first and second output switching elements OT1 and OT2, the second power supply voltage $V_{DD2}$ may be output via the gate terminal and output terminal ($V_{OUT}$) of the sixth output switching element OT6. Conversely, when the first intermediate voltage $V_{M1}$ having the second power supply voltage $V_{DD2}$ is applied to the gate terminals of the first and second output switching elements OT1 and OT2, the second ground voltage $V_{SS2}$ may be output via the gate terminal and output terminal ($V_{OUT}$) of the sixth output switching element OT6.

The third output switching element OT3 may include a PMOS. The gate terminal of the third output switching element OT3 may be connected to the second intermediate voltage $V_{M2}$. The source terminal of the third output switching element OT3 may be connected to the second power supply voltage terminal ($V_{DD2}$). The drain terminal of the third output switching element OT3 may be connected to the drain terminal of the fourth output switching element OT4 and the gate terminal of the fifth output switching element OT5.

The fourth output switching element OT4 may include an NMOS. The gate terminal of the fourth output switching element OT4 may be connected to the second intermediate voltage $V_{M2}$. The drain terminal of the fourth output switching element OT4 may be connected to the drain terminal of the third output switching element OT3 and the gate terminal of the fifth output switching element OT5. The source terminal of the fourth output switching element OT4 may be connected to the drain terminal of the sixth output switching element OT6.

The third and fourth output switching elements OT3 and OT4 may operate as inverters. Therefore, when the second intermediate voltage $V_{M2}$ having the second ground voltage level ($V_{SS2}$) is applied to the gate terminals of the third and fourth output switching elements OT3 and OT4, the second power supply voltage $V_{DD2}$ may be output via the gate terminal of the fifth output switching element OT5. Conversely, when the second intermediate voltage $V_{M2}$ having the second power supply voltage $V_{DD2}$ is applied to the gate terminals of the third and fourth output switching elements OT3 and OT4, the second ground voltage $V_{SS2}$ may be output via the gate terminal of the fifth output switching element OT5.

The fifth output switching element OT5 may include an NMOS. The gate terminal of the fifth output switching element OT5 may be connected to the drain terminal of the third output switching element OT3 and the drain terminal of the fourth output switching element OT4. The drain terminal of the fifth output switching element OT5 may be connected to the source terminal of the second output switching element OT2. The source terminal of the fifth output switching element OT5 may be connected to a bias voltage $V_B$.

The sixth output switching element OT6 may include an NMOS. The gate terminal of the sixth output switching element OT6 may be connected to the drain terminal of the first output switching element OT1 and the drain terminal of the second output switching element OT2. The drain terminal of the sixth output switching element OT6 may be connected to the source terminal of the fourth output switching element OT4. The source terminal of the sixth output switching element OT6 may be connected to the bias voltage $V_B$.

The metastable state-preventing circuit 160 may include first, second, and third metastable switching elements MT1, MT2, and MT3.

The first metastable switching element MT1 may include a PMOS. The gate terminal of the first metastable switching element MT1 may be connected to the second intermediate voltage $V_{M2}$. In this case, the first metastable switching element MT1 may be turned on or off based on the second intermediate voltage $V_{M2}$. The source terminal of the first metastable switching element MT1 may be connected to the second power supply voltage terminal ($V_{DD2}$). The drain terminal of the first metastable switching element MT1 may be connected to the second metastable switching element MT2.

The second metastable switching element MT2 may include a PMOS. The gate terminal of the second metastable switching element MT2 may be connected to the first intermediate voltage $V_{M1}$. In this case, the second metastable switching element MT2 may be turned on or off based on the first intermediate voltage $V_{M1}$. The source terminal of the second metastable switching element MT2 may be connected to the drain terminal of the first metastable switching element MT1. The drain terminal of the second metastable switching element MT2 may be connected to the third metastable switching element MT3.

The third metastable switching element MT3 may include a PMOS. The gate terminal of the third metastable switching element MT3 may be connected to the second gate voltage $V_{G2}$. In this case, the third metastable switching element MT3 may be turned on based on the second gate voltage $V_{G2}$. The source terminal of the third metastable switching element MT3 may be connected to the drain terminal of the second metastable switching element MT2. The drain terminal of the third metastable switching element MT3 may be connected to the drain terminal of the third protection switching element PT3 and the drain terminal of the fifth protection switching element PT5.

The third metastable switching element MT3 includes a PMOS, and the second gate voltage $V_{G2}$ is applied thereto via the gate terminal. Therefore, the third metastable switching element MT3 may remain turned on.

The first metastable switching element MT1 includes a PMOS and may be thus turned on when the second intermediate voltage $V_{M2}$ has a metastable voltage level (e.g., 0.8 V). Also, the second metastable switching element MT2 includes a PMOS and may be thus turned on when the first intermediate voltage $V_{M1}$ has a metastable voltage level.

In this case, when the level shifter 100 is in a metastable state with both the first intermediate voltage $V_{M1}$ and the second intermediate voltage $V_{M2}$ at a metastable voltage level, all three metastable switching elements MT1 to MT3 may be turned on. When the first to third metastable switching elements MT1 to MT3 are all turned on, the second power supply voltage $V_{DD2}$ is supplied to the drain terminal of the third protection switching element PT3 and the drain terminal of the fifth protection switching element PT5. Accordingly, the third intermediate voltage VM3 may be set to the second power supply voltage $V_{DD2}$. Therefore, current flows through the fifth protection switching element PT5 to the first intermediate voltage $V_{M1}$. This current flow causes a change in the voltage level of the first intermediate voltage $V_{M1}$ changes, which allows the level shifter 100 to escape from the metastable state. In summary, when both the first intermediate voltage $V_{M1}$ and the second intermediate voltage $V_{M2}$ have the metastable voltage level, the first to third metastable switching elements MT1 to MT3 are all turned on. Accordingly, the first intermediate voltage $V_{M1}$ and the second intermediate voltage $V_{M2}$ may escape from the metastable voltage level.

Even if the level shifter 100 falls into the metastable state, the level shifter 100 may immediately escape from the metastable state by using the metastable state-preventing circuit 160. Accordingly, the level shifter 100 may be prevented from remaining in the metastable state.

The auxiliary circuits 170_1 and 170_2 may include a first auxiliary switching element AT1 and a second auxiliary switching element AT2.

The first auxiliary switching element AT1 may include a PMOS. The gate terminal of the first auxiliary switching element AT1 may be connected to the drain terminal of the third protection switching element PT3 and the drain terminal of the fifth protection switching element PT5. In this case, the first auxiliary switching element AT1 may be turned on or off based on the third intermediate voltage $V_{M3}$. The source terminal of the first auxiliary switching element AT1 may be connected to the source terminal of the fifth protection switching element PT5. The drain terminal of the first auxiliary switching element AT1 may be connected to the bias voltage $V_B$.

When the third intermediate voltage $V_{M3}$ is at the first ground voltage level (Vssi), the first auxiliary switching element AT1 may be turned on to assist in adjusting the first intermediate voltage $V_{M1}$. In other words, when the third intermediate voltage $V_{M3}$ is at the first ground voltage level (Vssi), the first auxiliary switching element AT1 may be turned on so that the bias voltage $V_B$ is applied to the source terminal of the fifth protection switching element PT5. Accordingly, the first auxiliary switching element AT1 may assist in adjusting the first intermediate voltage $V_{M1}$ to the second ground voltage level ($V_{SS2}$).

The second auxiliary switching element AT2 may include a PMOS. The gate terminal of the second auxiliary switching element AT2 may be connected to the drain terminal of the fourth protection switching element PT4 and the drain terminal of the sixth protection switching element PT6. In this case, the second auxiliary switching element AT2 may be turned on or off based on the fourth intermediate voltage $V_{M4}$. The source terminal of the second auxiliary switching element AT2 may be connected to the source terminal of the sixth protection switching element PT6. The drain terminal of the second auxiliary switching element AT2 may be connected to the bias voltage $V_B$.

When the fourth intermediate voltage $V_{M4}$ is at the first ground voltage level (Vssi), the second auxiliary switching element AT2 may be turned on to assist in adjusting the second intermediate voltage $V_{M2}$. In other words, when the fourth intermediate voltage $V_{M4}$ is at the first ground voltage level (Vssi), the second auxiliary switching element AT2 may be turned on so that the bias voltage $V_B$ is applied to the source terminal of the sixth protection switching element PT6. Accordingly, the second auxiliary switching element AT2 may assist in adjusting the second intermediate voltage $V_{M2}$ to the second ground voltage level ($V_{SS2}$).

Even if leakage occurs in the level shifter 100, the first intermediate voltage $V_{M1}$ and the second intermediate voltage $V_{M2}$ may be adjusted to desired values by using the auxiliary circuits 170_1 and 170_2. Accordingly, the level shifter 100 may operate normally.

The capacitor circuits 180_1 and 180_2 may include first to fourth capacitors C1 to C4.

The first capacitor C1 may be connected in parallel to the first protection switching element PT1, the third protection switching element PT3, and the fifth protection switching element PT5. The first capacitor C1 may charge electric charges therein or discharge the electric charges when the first inverted voltage $V_{I1}$ swings between a first ground voltage Vssi and the first power supply voltage $V_{DD1}$. Accordingly, the first capacitor C1 may assist in rapidly changing the voltage level of the first intermediate voltage $V_{M1}$.

The second capacitor C2 may be connected in parallel to the second protection switching element PT2, the fourth protection switching element PT4, and the sixth protection switching element PT6. The second capacitor C2 may charge electric charges therein or discharge the electric charges when the second inverted voltage $V_{I2}$ swings between the first ground voltage Vssi and the first power supply voltage $V_{DD1}$. Accordingly, the second capacitor C2 may assist in rapidly changing the voltage level of the second intermediate voltage $V_{M2}$.

The third capacitor C3 may be connected in parallel to the first protection switching element PT1 and the third protection switching element PT3. The third capacitor C3 may charge electric charges therein or discharge the electric charges when the first inverted voltage $V_{I1}$ swings between the first ground voltage Vssi and the first power supply voltage $V_{DD1}$. Accordingly, the third capacitor C3 may assist in rapidly changing the voltage level of the third intermediate voltage $V_{M3}$.

The fourth capacitor C4 may be connected in parallel to the second protection switching element PT2 and the fourth protection switching element PT4. The fourth capacitor C4 may charge electric charges therein or discharge the electric charges when the second inverted voltage $V_{I2}$ swings between the first ground voltage Vssi and the first power supply voltage $V_{DD1}$. Accordingly, the fourth capacitor C4 may assist in rapidly changing the voltage level of the fourth intermediate voltage $V_{M4}$.

The level shifter 100 may operate at a faster speed by using the capacitor circuits 180_1 and 180_2 described above.

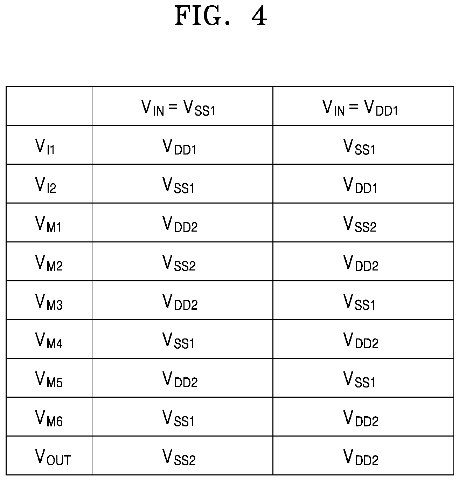

FIG. 4 is a table showing a change in voltage according to a level of input voltage that is input to a level shifter according to one or more embodiments.

Referring to FIG. 4, when the voltage level of an input voltage $V_{IN}$ is at a first ground voltage level (Vssi) and a first power supply voltage level ($V_{DD1}$), this table may show the voltage levels of first and second inverted voltages $V_{I1}$ and $V_{I2}$, first to sixth intermediate voltages $V_{M1}$ to $V_{M6}$, and an output voltage $V_{OUT}$.

First, when the voltage level of the input voltage $V_{IN}$ has the first ground voltage level (Vssi), the first inverted voltage $V_{I1}$ may have the first power supply voltage level ($V_{DD1}$) by the first inverter I1 and the second inverted voltage $V_{I2}$ may have the first ground voltage level (Vssi) by the second inverter I2.

When the first inverted voltage $V_{I1}$ has the first power supply voltage level ($V_{DD1}$), current may not flow via the first protection switching element PT1 and the third protection switching element PT3. Accordingly, the fifth intermediate voltage $V_{M5}$ and the third intermediate voltage $V_{M3}$ may have a second power supply voltage level ($V_{DD2}$). Conversely, when the second inverted voltage $V_{I2}$ has the first ground voltage level (Vssi), current may flow via the second protection switching element PT2 and the fourth protection switching element PT4. Accordingly, the sixth intermediate voltage $V_{M6}$ and the fourth intermediate voltage $V_{M4}$ may have the first ground voltage level (Vssi). Also, since the fourth intermediate voltage $V_{M4}$ has the first ground voltage level (Vssi), the second intermediate voltage $V_{M2}$ has a second ground voltage level ($V_{SS2}$). As described above, when the voltage level of the input voltage $V_{IN}$ has the first ground voltage level (Vssi), the protection circuit 120 may adjust the second intermediate voltage $V_{M2}$ based on the first and second inverted voltages $V_{I1}$ and $V_{I2}$.

When the second intermediate voltage $V_{M2}$ has the second ground voltage level ($V_{SS2}$), the first cross-switching element CT1 may be turned on. Accordingly, the first intermediate voltage $V_{M1}$ may have the second power supply voltage level ($V_{DD2}$). That is, when the voltage level of the input voltage $V_{IN}$ has the first ground voltage level (Vssi), the cross-coupling circuit 130 may adjust the first intermediate voltage $V_{M1}$ that is not adjusted by the protection circuit 120 among the first and second intermediate voltages $V_{M1}$ and $V_{M2}$.

When the first intermediate voltage $V_{M1}$ has the second power supply voltage level ($V_{DD2}$), the first intermediate voltage $V_{M1}$ may be inverted by the first and second output switching elements OT1 and OT2. Accordingly, the output voltage $V_{OUT}$ may have the second ground voltage level ($V_{SS2}$).

Next, when the voltage level of the input voltage $V_{IN}$ has the first power supply voltage level ($V_{DD1}$), the first inverted voltage $V_{I1}$ may have the first ground voltage level (Vssi) by the first inverter I1 and the second inverted voltage $V_{I2}$ may have the first power supply voltage level ($V_{DD1}$) by the second inverter I2.

When the first inverted voltage $V_{I1}$ has the first ground voltage level (Vssi), current may flow via the first protection switching element PT1 and the third protection switching element PT3. Accordingly, the fifth intermediate voltage $V_{M5}$ and the third intermediate voltage $V_{M3}$ may have the first ground voltage level (Vssi). Conversely, when the second inverted voltage $V_{I2}$ has the first power supply voltage level ($V_{DD1}$), current may not flow via the second protection switching element PT2 and the fourth protection switching element PT4. Accordingly, the sixth intermediate voltage $V_{M6}$ and the fourth intermediate voltage VM4 may have the second power supply voltage level ($V_{DD2}$). Also, since the third intermediate voltage $V_{M3}$ has the first ground voltage level (Vssi), the first intermediate voltage $V_{M1}$ has the second ground voltage level ($V_{SS2}$). As described above, when the voltage level of the input voltage $V_{IN}$ has the first power supply voltage level ($V_{DD1}$), the protection circuit 120 may adjust the first intermediate voltage $V_{M1}$ based on the first and second inverted voltages $V_{I1}$

and $V_{I2}$.

When the first intermediate voltage $V_{M1}$ has the second ground voltage level ($V_{SS2}$), the second cross-switching element CT2 may be turned on. Accordingly, the second intermediate voltage $V_{M2}$ may have the second power supply voltage level ($V_{DD2}$). That is, when the voltage level of the input voltage $V_{IN}$ has the first power supply voltage level ($V_{DD1}$), the cross-coupling circuit 130 may adjust the second intermediate voltage $V_{M2}$ that is not adjusted by the protection circuit 120 among the first and second intermediate voltages $V_{M1}$ and $V_{M2}$.

When the first intermediate voltage $V_{M1}$ has the second ground voltage level ($V_{SS2}$), the first intermediate voltage $V_{M1}$ may be inverted by the first and second output switching elements OT1 and OT2. Accordingly, the output voltage $V_{OUT}$ may have the second power supply voltage level ($V_{DD2}$).

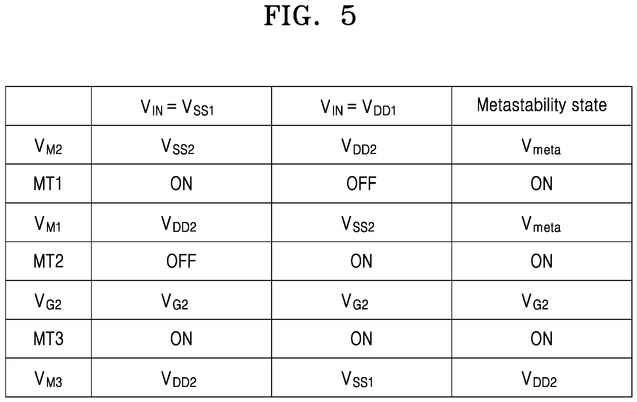

FIG. 5 is a table showing voltages input to and output from a metastable state-preventing circuit and states of metastable switching elements in a level shifter according to one or more embodiments.

Referring to FIG. 5, when the voltage level of the input voltage $V_{IN}$ has the first ground voltage level (Vssi) and the first power supply voltage level ($V_{DD1}$), and the level shifter 100 is in a metastable state (or shown as metastability state in FIG. 5), this table may show the voltage levels of voltages applied to gates of the first to third metastable switching elements MT1 to MT3, the states of the first to third metastable switching elements MT1 to MT3, and the voltage level of the third intermediate voltage $V_{M3}$.

First, when the voltage level of the input voltage $V_{IN}$ has the first ground voltage level (Vssi), the second intermediate voltage $V_{M2}$ may have the second ground voltage level ($V_{SS2}$) and the first intermediate voltage $V_{M1}$ may have the second power supply voltage level ($V_{DD2}$) as shown in FIGS. 4 and 5. In this case, the first metastable switching element MT1 may be turned on because the second intermediate voltage $V_{M2}$ has the second ground voltage level ($V_{SS2}$). The second metastable switching element MT2 may be turned off because the first intermediate voltage $V_{M1}$ has the second power supply voltage level ($V_{DD2}$). Also, since the second ground voltage level ($V_{SS2}$) is applied to the second gate voltage $V_{G2}$, the third metastable switching element MT3 may remain in an on state. In this case, since the first to third metastable switching elements MT1 to MT3 are not all turned on, the third intermediate voltage $V_{M3}$ may have the second power supply voltage level ($V_{DD2}$) as shown in FIGS. 4 and 5.

Next, when the voltage level of the input voltage $V_{IN}$ has the first power supply voltage level ($V_{DD1}$), the second intermediate voltage $V_{M2}$ may have the second power supply voltage level ($V_{DD2}$) and the first intermediate voltage $V_{M1}$ may have the second ground voltage level ($V_{SS2}$) as shown in FIGS. 4 and 5. In this case, the first metastable switching element MT1 may be turned off because the second intermediate voltage $V_{M2}$ has the second power supply voltage level ($V_{DD2}$). The second metastable switching element MT2 may be turned on because the first intermediate voltage $V_{M1}$ has the second ground voltage level ($V_{SS2}$). Also, since the second ground voltage level ($V_{SS2}$) is applied to the second gate voltage $V_{G2}$, the third metastable switching element MT3 may remain in the on state. In this case, since the first to third metastable switching elements MT1 to MT3 are not all turned on, the third intermediate voltage $V_{M3}$ may have the first ground voltage level (Vssi) as shown in FIGS. 4 and 5.

Finally, when the level shifter 100 is in a metastable state, the first intermediate voltage $V_{M1}$ and the second intermediate voltage $V_{M2}$ may have a metastable voltage level ($V_{meta}$). In this case, the first metastable switching element MT1 may be turned on because the second intermediate voltage $V_{M2}$ has the metastable voltage level ($V_{meta}$). Also, the second metastable switching element MT2 may be turned on because the first intermediate voltage $V_{M1}$ has the metastable voltage level ($V_{meta}$). Also, since the second gate voltage $V_{G2}$ always has the same voltage level as the second ground voltage level ($V_{SS2}$), the third metastable switching element MT3 may be turned on. At this time, since the first to third metastable switching elements MT1 to MT3 are all turned on, the second power supply voltage $V_{DD2}$ may be supplied to the drain terminal of the third protection switching element PT3 and the source terminal of the fifth protection switching element PT5. Accordingly, the third intermediate voltage $V_{M3}$ may have the second power supply voltage $V_{DD2}$.

FIG. 6 is a block diagram showing a bias generation circuit 150 of a level shifter according to one or more embodiments.

Referring to FIG. 6, the voltage terminal connected to the bias generation circuit 150 and the voltage output by the bias generation circuit 150 may be shown.

The bias generation circuit 150 may be connected between a second power supply voltage terminal ($V_{DD2}$) and a first ground voltage terminal (Vssi). The bias generation circuit 150 may generate a first gate voltage $V_{G1}$, a second gate voltage $V_{G2}$, and a bias voltage $V_B$ based on a second power supply voltage $V_{DD2}$ and a first ground voltage Vssi.

The bias generation circuit 150 may output the first gate voltage $V_{G1}$ to a gate terminal of a third protection switching element PT3 and a gate terminal of a fourth protection switching element PT4.

The bias generation circuit 150 may output the second gate voltage $V_{G2}$ to a gate terminal of a fifth protection switching element PT5, a gate terminal of a sixth protection switching element PT6, and a gate terminal of a third metastable switching element MT3.

The bias generation circuit 150 may output a bias voltage $V_B$ to a drain terminal of a first auxiliary switching element AT1, a drain terminal of a second auxiliary switching element AT2, a source terminal of a fifth output switching element OT5, and a source terminal of a sixth output switching element OT6.

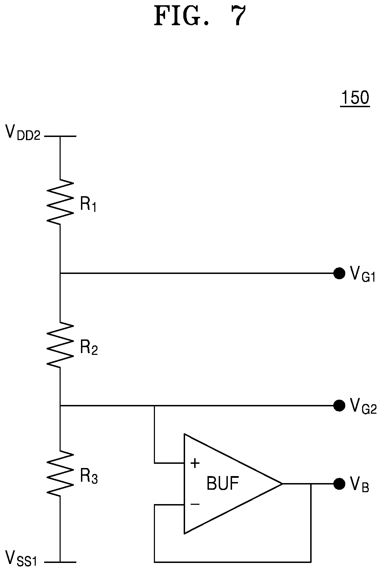

An example of the bias generation circuit 150 may be as shown in FIG. 7.

FIG. 7 is a circuit diagram showing an example of a bias generation circuit 150 of a level shifter according to one or more embodiments.

Referring to FIG. 7, the bias generation circuit 150 may include first, second, and third resistors $R_1$, $R_2$, and $R_3$ and a buffer BUF.

The first to third resistors $R_1$ to $R_3$ may be connected to each other in series between the second power supply voltage terminal ($V_{DD2}$) and the first ground voltage terminal (Vssi).

In more detail, one end of the first resistor $R_1$ may be connected to the second power supply voltage terminal ($V_{DD2}$). One end of the second resistor $R_2$ may be connected to the other end of the first resistor $R_1$. One end of the third resistor $R_3$ may be connected to the other end of the second resistor $R_2$. The other end of the third resistor $R_3$ may be connected to the first ground voltage terminal (Vssi).

The bias generation circuit 150 may output the first gate voltage $V_{G1}$ via a terminal (or a junction) between the first resistor $R_1$ and the second resistor $R_2$. Also, the bias generation circuit 150 may output the second gate voltage $V_{G2}$ via a terminal (or a junction) between the second resistor $R_2$ and the third resistor $R_3$.

In this case, a ratio of the resistance values of the first to third resistors $R_1$ to $R_3$ may be determined according to the voltage levels of the second power supply voltage $V_{DD2}$, the first ground voltage Vssi, the first gate voltage $V_{G1}$, and the second gate voltage $V_{G2}$. The ratio described above may be expressed as Equation 1 below.

[Equation 1]

$$R_1 : R_2 : R_3 = (V_{DD2} - V_{G1}) : (V_{G1} - V_{G2}) : (V_{G2} - V_{SS1})$$

For example, the ratio of the resistance values of the first to third resistors $R_1$ to $R_3$ may be 5:2:5, when the second power supply voltage $V_{DD2}$ is 1.2 V, the first ground voltage Vssi is 0 V, the first gate voltage $V_{G1}$ is 0.7 V, and the second gate voltage $V_{G2}$ is 0.5 V.

The positive input terminal (+) of the buffer BUF may be connected to an terminal between the second resistor $R_2$ and the third resistor $R_3$. The negative input terminal (-) of the buffer BUF may be connected to the output terminal of the buffer BUF. The bias generation circuit 150 may output the bias voltage $V_B$ via the output terminal of the buffer BUF. In this case, the bias voltage $V_B$ may have the same voltage level as the second gate voltage $V_{G2}$.

As described above, the bias voltage $V_B$ is output via the buffer BUF, and thus, it is possible to prevent current from flowing back from the drain terminal of the first auxiliary switching element AT1 the drain terminal of the second auxiliary switching element AT2, the source terminal of the fifth output switching element OT5, and the source terminal of the sixth output switching element OT6, which receive the bias voltage $V_B$.

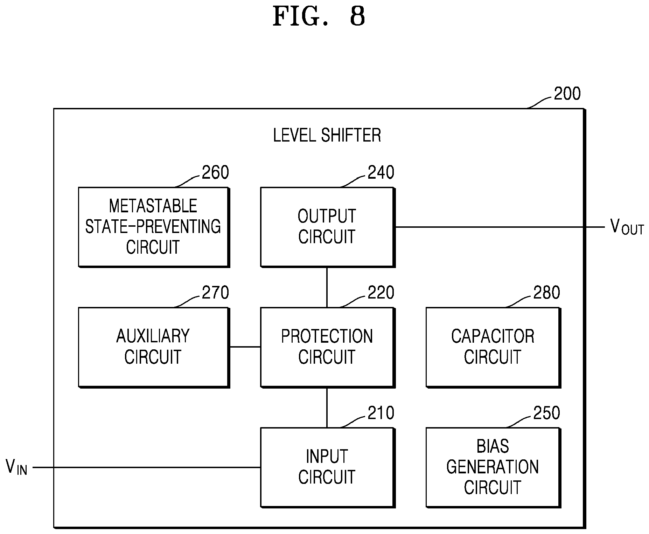

FIG. 8 is a block diagram showing another example of a level shifter 200 according to one or more embodiments.

Referring to FIG. 8, the level shifter 200 according to one or more embodiments may include an input circuit 210, a protection circuit 220, and an output circuit 240. Also, the level shifter 200 according to one or more embodiments may further include at least one of a bias generation circuit 250, a metastable state-preventing circuit 260, an auxiliary circuit 270, and a capacitor circuit 280.

In this case, the input circuit 210, the protection circuit 220, the bias generation circuit 250, the metastable state-preventing circuit 260, the auxiliary circuit 270, and the capacitor circuit 280 of the embodiment of FIG. 8 may be the same or substantially the same as the input circuit 110, the protection circuit 120, the bias generation circuit 150, the metastable state-preventing circuit 160, the auxiliary circuit 170, and the capacitor circuit 180 of the embodiment of FIG. 1, respectively. Therefore, the description focuses on differences therebetween.

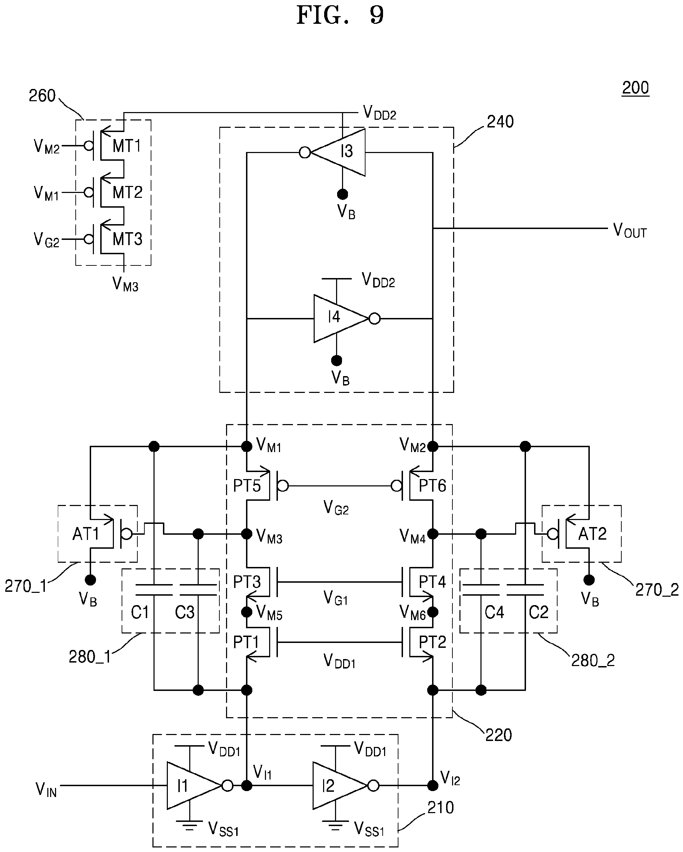

In FIG. 8, the level shifter 200 may not include a cross-coupling circuit. In the embodiment of FIG. 8, the level shifter 200 may use the output circuit 240 to perform both the operation of the cross-coupling circuit 130 and the operation of the output circuit 140 of the embodiment of FIG. 1. The structure of the output circuit 240 may be shown in more detail with reference to FIG. 9.

FIG. 9 is a circuit diagram showing another example of the level shifter 200 according to one or more embodiments.

Referring to FIG. 9, the output circuit 240 may include a third inverter I3 and a fourth inverter I4.

The third inverter I3 may be connected between a second power supply voltage terminal ($V_{DD2}$) and a bias voltage terminal $V_B$. An input terminal of the third inverter I3 may be connected to a source terminal of a sixth protection switching element PT6. An output terminal of the third inverter I3 may be connected to a source terminal of a fifth protection switching element PT5. The third inverter I3 may invert a second intermediate voltage $V_{M2}$ and output a first intermediate voltage $V_{M1}$.

As can be seen in FIG. 4, when the input voltage $V_{IN}$ has the first ground voltage level (Vssi), the second intermediate voltage $V_{M2}$ may have the second ground voltage level ($V_{SS2}$). In this case, the third inverter I3 may invert the second intermediate voltage $V_{M2}$ having the second ground voltage level ($V_{SS2}$) and output the first intermediate voltage

$V_{M1}$ having the second power supply voltage level ($V_{DD2}$). In this case, the second ground voltage level ($V_{SS2}$), which is the second intermediate voltage $V_{M2}$, may be output as the output voltage $V_{OUT}$.

The fourth inverter I4 may be connected between the second power supply voltage terminal ($V_{DD2}$) and the bias voltage terminal $V_B$. An input terminal of the fourth inverter I4 may be connected to the source terminal of the fifth protection switching element PT5. An output terminal of the fourth inverter I4 may be connected to the source terminal of the sixth protection switching element PT6. The fourth inverter I4 may invert the first intermediate voltage $V_{M1}$ and output the second intermediate voltage $V_{M2}$.

As can be seen in FIG. 4, when the input voltage $V_{IN}$ has the first power supply voltage level ($V_{DD1}$), the first intermediate voltage $V_{M1}$ may have the second ground voltage level ($V_{SS2}$). In this case, the fourth inverter I4 may invert the first intermediate voltage $V_{M1}$ having the second ground voltage level ($V_{SS2}$) and output the second intermediate voltage $V_{M2}$ having the second power supply voltage level ($V_{DD2}$). In this case, the second power supply voltage level ($V_{DD2}$), which is the second intermediate voltage $V_{M2}$, may be output as the output voltage $V_{OUT}$.

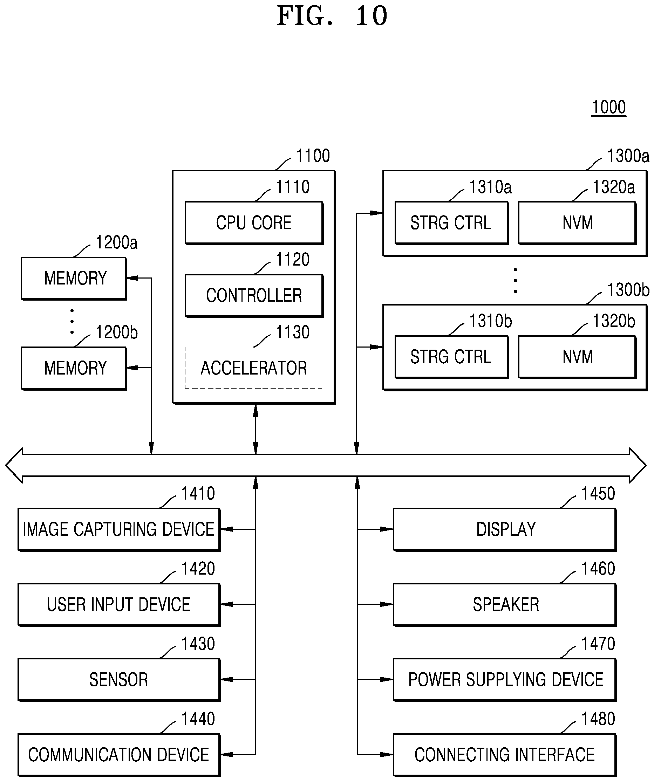

FIG. 10 is a block diagram showing a system 1000 including a level shifter according to one or more embodiments.

The system 1000 of FIG. 10 may include mobile systems, such as a portable mobile phone, a smartphone, a tablet personal computer (PC), a wearable device, a healthcare device, and an internet of things (IoT) device. However, the system 1000 of FIG. 10 is not necessarily limited to the mobile systems described above and may include a PC, a laptop, a server, a media player, an automotive device, such as a navigation unit, or the like.

Referring to FIG. 10, the system 1000 may include a main processor 1100, memory 1200a and 1200b, and storage devices 1300a and 1300b, and may further include one or more of an image capturing device 1410, a user input device 1420, a sensor 1430, a communication device 1440, a display 1450, a speaker 1460, a power supplying device 1470, and a connecting interface 1480. In this case, the components that constitute the system 1000 of FIG. 10, that is, the main processor 1100, the memory 1200a and 1200b, the storage devices 1300a and 1300b, the image capturing device 1410, the user input device 1420, the sensor 1430, the communication device 1440, the display 1450, the speaker 1460, the power supplying device 1470, and the connecting interface 1480 may each include one or more switching elements. In this case, the voltage applied to one or more switching elements in the components of FIG. 10 may be generated using the level shifters 100 and 200 according to the embodiments described above with reference to FIGS. 1 to 9.

The main processor 1100 may control all operations of the system 1000, and more specifically, the operation of all other components that constitute the system 1000. This main processor 1100 may be provided as a general-purpose processor, a dedicated processor, or an application processor.

The main processor 1100 may include one or more CPU cores 1110 and may further include a controller 1120 for controlling the memory 1200a and 1200b and/or the storage devices 1300a and 1300b. According to one or more embodiments, the main processor 1100 may further include an accelerator 1130, which includes a dedicated circuit for high-speed data computation, such as artificial intelligence (AI) data computation. The accelerator 1130 may include a graphics processing unit (GPU), an neural processing unit (NPU), and/or a data processing unit (DPU) and may be provided as a separate chip physically independent from other components of the main processor 1100.

The memory 1200a and 1200b may be used as main memory devices of the system 1000 and include volatile memory, such as static random access memory (SRAM) and/or dynamic random access memory (DRAM). However, the memory 1200a and 1200b may also include non-volatile memory, such as flash memory, phase-change random access memory (PRAM), and/or resistive random access memory (RRAM). The memory 1200a and 1200b may also be provided in the same package as the main processor 1100.

The storage devices 1300a and 1300b may function as non-volatile storage devices for storing data regardless of whether power is supplied or not and may have storage capacities relatively greater than those of the memory 1200a and 1200b. The storage devices 1300a and 1300b may respectively include storage controllers 1310a and 1310b and non-volatile memory 1320a and 1320b that store data under the control by the storage controllers 1310a and 1310b. The non-volatile memory 1320a and 1320b may include flash memory with a 2-dimensional (2D) structure or a 3-dimensional (3D) vertical NAND (V-NAND) structure but may also include other types of non-volatile memory, such as PRAM and/or RRAM.

The storage devices 1300a and 1300b may be provided in the system 1000 while being physically separated from the main processor 1100 or may be provided in the same package as the main processor 1100. In addition, the storage devices 1300a and 1300b may have a form of a solid state device (SSD) or a memory card and may be thus detachably coupled to other components of the system 1000 via an interface, such as the connecting interface 1480 described below. The storage devices 1300a and 1300b may include devices, to which standard regulations are applied, such as a universal flash storage (UFS), an embedded multi-media card (eMMC), and a non-volatile memory express (NVMe), but the embodiment is not necessarily limited thereto.

The image capturing device 1410 may capture still images or moving images and may include a camera, a camcorder, and/or a webcam.

The user input device 1420 may receive various types of data input from a user of the system 1000 and may include a touch pad, a keypad, a keyboard, a mouse, and/or a microphone.

The sensor 1430 may detect various types of physical quantities obtained from outside the system 1000 and convert the sensed physical quantities into electric signals. This sensor 1430 may include a temperature sensor, a pressure sensor, an illuminance sensor, a position sensor, an acceleration sensor, a biosensor, and/or a gyroscope sensor.

The communication device 1440 may transmit signals to and receive signals from other devices outside the system 1000 according to various communication protocols. This communication device 1440 may include an antenna, a transceiver, and/or a modem.

The display 1450 and the speaker 1460 may function as output devices that output visual information and auditory information, respectively, to a user of the system 1000.

The power supplying device 1470 may appropriately convert power supplied from a battery built in the system 1000 and/or an external power source and may supply the converted power to each of the components of the system 1000.

The connecting interface 1480 may provide connection between the system 1000 and an external device which is connected to the system 1000 to exchange data with the system 1000. The connecting interface 1480 may be provided in various interface methods, such as an advanced technology attachment (ATA), a serial ATA (SATA), an external SATA (e-SATA), a small computer small interface (SCSI), a serial attached SCSI (SAS), a peripheral component interconnect (PCI), a PCI express (PCIe), an NVM express (NVMe), IEEE 1394, a universal serial bus (USB), a secure digital (SD) card, a multi-media card (MMC), an eMMC, a UFS, an embedded universal flash storage (eUFS), and a compact flash (CF) card.

The foregoing embodiments are merely examples and are not to be construed as limiting. The present teaching can be readily applied to other types of apparatuses. Also, the description of the embodiments is intended to be illustrative, and not to limit the scope of the claims, and many alternatives, modifications, and variations will be apparent to those skilled in the art.

**Claims**

1. A level shifter comprising:

   an input circuit (110) configured to invert an input voltage (VIN) to output a first inverted voltage (VI1) and a second inverted voltage (VI2), wherein the input voltage (VIN) swings between a first ground voltage (VSS1) and a first power supply voltage (VDD1);
   a protection circuit (120) comprising at least one pair of transistors (PT1 to PT6) sharing a gate terminal configured to adjust, based on the first inverted voltage (VI1) and the second inverted voltage (VI2), one of a first intermediate voltage (VM1) and a second intermediate voltage (VM2) of the protection circuit (120);
   a cross-coupling circuit (130) configured to adjust the other of the first intermediate voltage (VM1) and the second intermediate voltage (VM2); and
   an output circuit (140) configured to invert the first intermediate voltage (VM1) to output an output voltage that swings between a second ground voltage (VSS2) and a second power supply voltage (VDD2).

2. The level shifter of claim 1, wherein the input circuit (110) comprises:

   a first inverter (I1) configured to invert the input voltage (VIN) to output the first inverted voltage (VI1); and
   a second inverter (I2) configured to invert the first inverted voltage (VI1) to output the second inverted voltage (VI2).

3. The level shifter of claim 1 or 2, wherein the at least one pair of transistors (PT1 to PT6) of the protection circuit (120) comprises a first pair of transistors (PT1, PT2) configured to be turned on based on the first power supply voltage (VDD1), a second pair of transistors (PT3, PT4) configured to be turned on based on a first gate voltage (VG1), and a third pair of transistors (PT5, PT6) configured to be turned on based on a second gate voltage (VG2),

   the first pair of transistors (PT1, PT2) comprises a first protection switching element (PT1) configured to receive the first inverted voltage (VI1) and a second protection switching element (PT2) configured to receive the second inverted voltage (VI2),
   the second pair of transistors (PT3, PT4) comprises a third protection switching element (PT3) connected to the first protection switching element (PT1) and a fourth protection switching element connected (PT4) to the second protection switching element (PT2), and
   the third pair of transistors (PT5, PT6) comprises a fifth protection switching element (PT5) connected to the third protection switching element (PT3), and a sixth protection switching element (PT6) connected to the fourth protection switching element (PT4).

4.  The level shifter of claim 3, further comprising a bias generation circuit (150) connected to a second power supply voltage terminal (VDD2) and a first ground voltage terminal (VSS1) configured to generate the first gate voltage (VG1), the second gate voltage (VG2), and a bias voltage (VB).

5.  The level shifter of claim 4, wherein the bias generation circuit (150) comprises a buffer (BUF) configured to buffer the second gate voltage (VG2) to output the bias voltage (VB).

6.  The level shifter of claim 1, further comprising a metastable state-preventing circuit (160) configured to allow the first intermediate voltage (VM1) and the second intermediate voltage (VM2) to escape from a metastable voltage level when the first intermediate voltage (VM1) and the second intermediate voltage (VM2) are at the metastable voltage level.

7.  The level shifter of claim 6, wherein the at least one pair of transistors (PT1 to PT6) of the protection circuit (120) comprises a first pair of transistors (PT1, PT2) configured to be turned on based on the first power supply voltage (VDD1), a second pair of transistors (PT3, PT4) configured to be turned on based on a first gate voltage (VG1), and a third pair of transistors (PT5, PT6) configured to be turned on based on a second gate voltage (VG2), and wherein the metastable state-preventing circuit (160) comprises:

    a first metastable switching element (MT1) connected to the second power supply voltage (VDD2) and configured to be turned on or off based on the second intermediate voltage (VM2);
    a second metastable switching element (MT2) connected to the first metastable switching element (MT1) and configured to be turned on or off based on the first intermediate voltage (VM1); and
    a third metastable switching element (MT3) connected to the second metastable switching element (MT2) and configured to be turned on based on the second gate voltage (VG2).

8.  The level shifter of claim 7, wherein the first metastable switching element (MT1) is turned on when the second intermediate voltage (VM2) is at the metastable voltage level, and
    the second metastable switching element (MT2) is turned on when the first intermediate voltage (VM1) is at the metastable voltage level.

9.  The level shifter of claim 1, further comprising an auxiliary circuit (170_1, 170_2) connected to a bias voltage (VB) and configured to assist in adjusting the first intermediate voltage (VM1) and the second intermediate voltage (VM2).

10. The level shifter of claim 9, wherein the at least one pair of transistors (PT1 to PT6) of the protection circuit (120) comprises:

    a first protection switching element (PT1) and a second protection switching element (PT2), which are configured to be turned on based on the first power supply voltage (VDD1);
    a third protection switching element (PT3) and a fourth protection switching element (PT4), which are configured to be turned on based on a first gate voltage (VG1); and
    a fifth protection switching element (PT5) and a sixth protection switching element (PT6), which are configured to be turned on based on a second gate voltage (VG2), and

    wherein the auxiliary circuit (170_1, 170_2) comprises:

    a first auxiliary switching element (AT1) connected to the bias voltage (VB) and configured to be turned on based on a voltage between the third protection switching element (PT3) and the fifth protection switching element (PT5) to assist in adjusting the first intermediate voltage (VM1); and
    a second auxiliary switching element (AT2) connected to the bias voltage (VB) and configured to be turned on based on a voltage between the fourth protection switching element (PT4) and the sixth protection switching element (PT6) to assist in adjusting the second intermediate voltage (VM2).

11. The level shifter of claim 1, wherein the at least one pair of transistors (PT1 to PT6) of the protection circuit (120) comprises:

    a first protection switching element (PT1) and a second protection switching element (PT2), which are configured to be turned on based on the first power supply voltage (VDD1);
    a third protection switching element (PT3) and a fourth protection switching element (PT4), which are configured to be turned on based on a first gate voltage (VG1); and

a fifth protection switching element (PT5) and a sixth protection switching element (PT6), which are configured to be turned on based on a second gate voltage (VG2), and

wherein the level shifter further comprises a capacitor circuit (180_1, 180_2) comprising:

a first capacitor (C1) connected in parallel to the first protection switching element (PT1), the third protection switching element (PT3), and the fifth protection switching element (PT5);

a second capacitor (C2) connected in parallel to the second protection switching element (PT2), the fourth protection switching element (PT4), and the sixth protection switching element (PT6);

a third capacitor (C3) connected in parallel to the first protection switching element (PT1) and the third protection switching element (PT3); and

a fourth capacitor (C4) connected in parallel to the second protection switching element (PT2) and the fourth protection switching element (PT4).

12. A level shifter comprising:

an input circuit (110) configured to invert an input voltage (VIN) to output a first inverted voltage (VI1) and a second inverted voltage (VI2), wherein the input voltage (VIN) swings between a first ground voltage level (VSS1) and a first power supply voltage level (VDD1);

a protection circuit (120) configured to adjust, based on the first inverted voltage (VI1) and the second inverted voltage (VI2), one of a first intermediate voltage (VM1) and a second intermediate voltage (VM2);

a cross-coupling circuit (130) configured to adjust the other of the first intermediate voltage (VM1) and the second intermediate voltage (VM2);

an output circuit (140) configured to invert the first intermediate voltage (VM1) to output an output voltage that swings between a second ground voltage level (VSS2) and a second power supply voltage level (VDD2); and

a metastable state-preventing circuit (160) configured to allow the first intermediate voltage (VM1) and the second intermediate voltage (VM2) to escape from a metastable voltage level when the first intermediate voltage (VM1) and the second intermediate voltage (VM2) are at the metastable voltage level.

13. The level shifter of claim 12, wherein the metastable state-preventing circuit comprises:

a first metastable switching element (MT1) connected to a second power supply voltage ($V_{DD2}$) and configured to be turned on or off based on the second intermediate voltage (VM2);

a second metastable switching element (MT2) connected to the first metastable switching element (MT1) and configured to be turned on or off based on the first intermediate voltage (VM1); and

a third metastable switching element (MT3) connected to the second metastable switching element (MT2) and configured to be turned on based on a second gate voltage (VG2).

14. The level shifter of claim 13, wherein the first metastable switching element (MT1) is configured to be turned on when the second intermediate voltage (VM2) is at the metastable voltage level, and

the second metastable switching element (MT2) is configured to be turned on when the first intermediate voltage (VM1) is at the metastable voltage level.

15. The level shifter of any one of claims 12 to 14, wherein the protection circuit (120) comprises:

a first protection switching element (PT1) and a second protection switching element (PT2), which are configured to be turned on based on a first power supply voltage (VDD1);

a third protection switching element (PT3) and a fourth protection switching element (PT4), which are configured to be turned on based on a first gate voltage (VG1); and

a fifth protection switching element (PT5) and a sixth protection switching element (PT6), which are configured to be turned on based on a second gate voltage (VG2).

## FIG. 1

FIG. 2

FIG. 3

# FIG. 4

| | $V_{IN} = V_{SS1}$ | $V_{IN} = V_{DD1}$ |
|---|---|---|
| $V_{I1}$ | $V_{DD1}$ | $V_{SS1}$ |
| $V_{I2}$ | $V_{SS1}$ | $V_{DD1}$ |
| $V_{M1}$ | $V_{DD2}$ | $V_{SS2}$ |
| $V_{M2}$ | $V_{SS2}$ | $V_{DD2}$ |
| $V_{M3}$ | $V_{DD2}$ | $V_{SS1}$ |
| $V_{M4}$ | $V_{SS1}$ | $V_{DD2}$ |
| $V_{M5}$ | $V_{DD2}$ | $V_{SS1}$ |
| $V_{M6}$ | $V_{SS1}$ | $V_{DD2}$ |
| $V_{OUT}$ | $V_{SS2}$ | $V_{DD2}$ |

# FIG. 5

| | $V_{IN} = V_{SS1}$ | $V_{IN} = V_{DD1}$ | Metastability state |
|---|---|---|---|
| $V_{M2}$ | $V_{SS2}$ | $V_{DD2}$ | $V_{meta}$ |
| MT1 | ON | OFF | ON |
| $V_{M1}$ | $V_{DD2}$ | $V_{SS2}$ | $V_{meta}$ |
| MT2 | OFF | ON | ON |
| $V_{G2}$ | $V_{G2}$ | $V_{G2}$ | $V_{G2}$ |
| MT3 | ON | ON | ON |
| $V_{M3}$ | $V_{DD2}$ | $V_{SS1}$ | $V_{DD2}$ |

# FIG. 6

$V_{DD2}$

150

BIAS
GENERATION
CIRCUIT

$V_{G1}$

$V_{G2}$

$V_B$

$V_{SS1}$

# FIG. 7

# FIG. 8

LEVEL SHIFTER — 200

METASTABLE STATE-PREVENTING CIRCUIT — 260

OUTPUT CIRCUIT — 240

$V_{OUT}$

AUXILIARY CIRCUIT — 270

PROTECTION CIRCUIT — 220

CAPACITOR CIRCUIT — 280

$V_{IN}$

INPUT CIRCUIT — 210

BIAS GENERATION CIRCUIT — 250

# FIG. 9

# FIG. 10

1000